# EUROPEAN PATENT APPLICATION

(11) **EP 4 130 336 A1**
(43) Date of publication of application: **08.02.2023**
(21) Application number: 21775031.4
(22) Date of filing: 23.03.2021
(51) Int. Cl.: C23C 16/511, H05H 1/24

(54) **ATMOSPHERIC PRESSURE REMOTE PLASMA CVD DEVICE, FILM FORMATION METHOD, AND PLASTIC BOTTLE MANUFACTURING METHOD**

(30) Priority: 25.03.2020 JP 2020054661
(71) Applicant: Suntory Holdings Limited, Osaka 530-8203 (JP)
(72) Inventor: NISHIYAMA, Masanori, Tokyo 135-8631 (JP); AKANUMA, Yasuhiko, Tokyo 135-8631 (JP); SUZUKI, Tetsuya, Yokohama-shi, Kanagawa 224-0033 (JP); SHIRAKURA, Akira, Tokyo 150-0031 (JP); TANAKA, Takumi, Kawasaki-shi, Kanagawa 213-0006 (JP); MIKAMOTO, Kotono, Yokohama-shi, Kanagawa 224-0012 (JP)
(74) Representative: Vossius & Partner Patentanwälte Rechtsanwälte mbB
(86) International application number: PCT/JP2021/012030
(87) International publication number: WO 2021/193651

(57) **Abstract**

A plasma CVD device which comprises a substrate having a three-dimensional shape such as that of a bottle and which can form a coating on the surface of various substrates under atmospheric pressure, and a coating forming method are provided. This atmospheric pressure remote plasma CVD device is provided with a dielectric chamber which has a gas inlet, an inner space and a plasma outlet, and a plasma generation device which generates plasma in the inner space. The plasma outlet is provided with a nozzle that has an opening area smaller than the average cross-sectional area of the cross-sections perpendicular to the direction of gas flow in the inner space.

## Description

### FIELD

The present disclosure relates to an atmospheric pressure remote plasma CVD apparatus, a coating formation method, and a plastic bottle production method. More specifically, the present disclosure relates to an atmospheric pressure remote plasma CVD apparatus with which functional coatings, such as coatings having high gas barrier properties, can be formed by turning a raw material gas into a plasma at atmospheric pressure or pressure near atmospheric pressure, as well as a coating formation method and a plastic bottle production method using the same.

### BACKGROUND

Coating with a carbon film or an inorganic film to improve the gas barrier property or surface protection property of plastic products, such as films, sheets, and molded products, is known. For example, the formation of a coating on the inner surface of a plastic bottle used for beverages or the like is known. As such a coating, carbon films, such as diamond-like carbon (DLC, also referred to as hydrogenated amorphous carbon) films, and inorganic films, such as silicon oxide (SiOₓ) films, are known. When thermal plasma generated near atmospheric pressure is used to form a coating of a DLC film or SiOₓ film, the plastic material decomposes or deforms, and thus, chemical vapor deposition (CVD) with low-temperature plasma in a vacuum (several Pa to several tens of Pa) is commonly used. For example, polyethylene terephthalate (PET) has a heat distortion temperature of approximately 80°C and is decomposed or deformed by thermal plasma, and thus, CVD coating with low temperature plasma is required.

In order to generate plasma inside a plastic bottle by applying high frequency radiation or microwaves, it is necessary to reduce the pressure inside the plastic bottle to 100 Pa or less. However, in terms of the cost of high-performance vacuum pumps and vacuum equipment required to obtain a high vacuum, as well as the power and time to reach the vacuum, treatment under high vacuum of 100 Pa or less is significantly disadvantageous as compared with treatment under atmospheric pressure or treatment under a low vacuum of 1000 Pa (approximately 0.01 atm) or more, which can be reached in a short time using a simple rotary pump.

When coating a plastic bottle, the space for accommodating the bottle, for example, the microwave confinement chamber, must be depressurized to a pressure such that the bottle is not crushed by external pressure and plasma is not excited outside the bottle, for example, approximately 10,000 Pa (approximately 0.1 atm). Thus, it is necessary that the plastic bottles have the strength to withstand the difference between external pressure and internal pressure and maintain their shape, and low temperature plasma treatment under vacuum of thin and lightweight bottles or large capacity thin bottles of 1 liter or more is difficult.

In order to generate low temperature plasma which can be used to form a coating on a plastic bottle under atmospheric pressure without using a high vacuum, it is necessary to suppress the formation of thermal plasma under atmospheric pressure and to form a non-equilibrium plasma in which the electron temperature is high but the ion is maintained at a low temperature. The coating of a plastic bottle with a barrier film by such an atmospheric pressure low temperature plasma method is known.

Patent Literature 1 (JP 2005-313939 A) describes a method for the production of a gas barrier thin film-coated plastic bottle, comprising at least the steps of generating, using an atmospheric pressure plasma method, a plasma of a raw material gas of the gas barrier thin film so as to contact or substantially contact the outer surface of the bottle, and spraying the plasma-excited raw material gas over the entire outer surface from a close distance to form a gas barrier thin film.

Patent Literature 2 (JP 2012-172208 A) describes a plastic bottle inner surface treatment method, comprising arranging a plastic bottle to be treated inside a microwave confinement chamber, introducing microwaves into the interior of the microwave confinement chamber, and turning a gas containing a raw material gas supplied through a gas supply pipe arranged inside the plastic bottle into a plasma, wherein the gas supply pipe is formed by arranging a thin rod member composed of a conductor inside a supply pipe body composed of a cylindrical dielectric, and microwaves are introduced by an annular resonator through slot antennas, which are arranged around the microwave confinement chamber and provided on the surface facing the microwave confinement chamber, into the interior of the microwave confinement chamber to cause the thin rod member to discharge electricity and ignite plasma, whereby plasma is generated inside the plastic bottle, and the generation of plasma is maintained by the introduction of microwaves to turn the gas containing the raw material gas supplied by the gas supply pipe into a plasma.

### [CITATION LIST]

### [PATENT LITERATURE]

[PTL 1] JP 2005-313939 A
[PTL 2] JP 2012-172208 A

### SUMMARY

### [TECHNICAL PROBLEM]

In the method described in Patent Literature 1, since it is necessary that the distance between the electrode and the surface of the plastic bottle be several millimeters, coating formation is limited to the outer surface of the bottle, and a device for rotating the bottle is also required. In the method described in Patent Literature 2, since the plastic bottle is arranged inside the microwave confinement chamber, it is necessary to design the microwave confinement chamber in accordance with the size and shape of the bottle, and equipment and time for the placement and removal of bottles are needed. Thus, it is disadvantageous in terms of cost reduction when processing a large amount of plastic bottles having various sizes and shapes.

An object of the present disclosure is to provide a plasma CVD apparatus and a coating formation method with which coatings can be formed under atmospheric pressure on the surfaces of various substrates including substrates having three-dimensional shapes, such as plastic bottles, without the need to design the deposition chamber in accordance with the sizes and shapes of the substrates, and without the need for equipment and time for the placement and removal of the substrates.

### [SOLUTION TO PROBLEM]

The present disclosure encompasses Aspects [1] to [16] below.
[1] An atmospheric pressure remote plasma CVD apparatus, comprising a dielectric chamber having a gas inlet, an internal space, and a plasma outlet, and a plasma generator which generates plasma in the internal space, wherein the plasma outlet comprises a nozzle having an opening area smaller than an average cross-sectional area of a cross-section orthogonal to a gas flow direction of the internal space.
[2] The atmospheric pressure remote plasma CVD apparatus according to [1], wherein the dielectric chamber is tubular, and in the longitudinal direction of the dielectric chamber, the gas inlet is arranged at one end of the dielectric chamber and the plasma outlet is arranged at the other end of the dielectric chamber.
[3] The atmospheric pressure remote plasma CVD apparatus according to [1] or [2], wherein the dielectric chamber comprises at least one selected from the group consisting of glass, quartz, and a fluororesin.
[4] The atmospheric pressure remote plasma CVD apparatus according to any one of [1] to [3], wherein the plasma generator is a microwave irradiation device.
[5] The atmospheric pressure remote plasma CVD apparatus according to any one of [1] to [4], wherein the opening area of the nozzle is 0.01 to 0.1 times the average cross-sectional area of the cross-section orthogonal to the gas flow direction of the internal space.
[6] The atmospheric pressure remote plasma CVD apparatus according to any one of [1] to [5], further comprising a conductor which can be arranged in, inserted into, and removed from the internal space.
[7] The atmospheric pressure remote plasma CVD apparatus according to [6], wherein the conductor comprises an insulation sheath which extends from the gas inlet of the dielectric chamber.
[8] The atmospheric pressure remote plasma CVD apparatus according to any one of [1] to [7], further comprising a raw material gas supply line which is open in an upstream part, middle part, or downstream part of the internal space, wherein a plasma-excited carrier gas and a raw material gas are mixed in the internal space.
[9] The atmospheric pressure remote plasma CVD apparatus according to any one of [1] to [8], comprising a raw material supply mechanism for introducing a fluororesin or hydrocarbon thermosetting resin rod-shaped object into the internal space.
[10] The atmospheric pressure remote plasma CVD apparatus according to any one of [1] to [9], further comprising a conductor which is arranged downstream of the plasma outlet and to which a negative voltage can be applied, wherein the conductor is configured so that a substrate is arranged between the plasma outlet and the conductor.
[11] The atmospheric pressure remote plasma CVD apparatus according to any one of [1] to [10], wherein the dielectric chamber has a plurality of plasma outlets, and a total opening area of the nozzles of the plurality of plasma outlets is less than the average cross-sectional area of the cross-section orthogonal to the gas flow direction of the internal space.
[12] A method for forming a coating on a surface of a substrate, comprising:
   providing an atmospheric pressure remote plasma CVD apparatus comprising a dielectric chamber having a gas inlet, an internal space, and a plasma outlet, and a plasma generator which generates plasma in the internal space, the plasma outlet comprising a nozzle having an opening area smaller than an average cross-sectional area of a cross-section orthogonal to a gas flow direction of the internal space,
   arranging a substrate downstream of the plasma outlet,
   introducing a carrier gas from the gas inlet,
   turning the carrier gas into a plasma in the internal space,
   introducing a raw material gas from the gas inlet,
   mixing the raw material gas and the plasma-excited carrier gas to generate a plasma-excited raw material gas, and
   ejecting the plasma-excited raw material gas from the plasma outlet toward the substrate to form a coating on the surface of the substrate.
[13] A method for producing a plastic bottle having a coated inner surface, comprising:
   providing an atmospheric pressure remote plasma CVD apparatus comprising a dielectric chamber having a gas inlet, an internal space, and a plasma outlet, and a plasma generator which generates plasma in the internal space, the plasma outlet comprising a nozzle having an opening area smaller than an average cross-sectional area of a cross-section orthogonal to a gas flow direction of the internal space,
   arranging a plastic bottle downstream of the plasma outlet,
   introducing a carrier gas from the gas inlet,
   turning the carrier gas into a plasma in the internal space,
   introducing a raw material gas from the gas inlet,
   mixing the raw material gas and the plasma-excited carrier gas to generate a plasma-excited raw material gas, and
   ejecting the plasma-excited raw material gas from the plasma outlet toward an interior of the plastic bottle to form a coating on an inner surface of the plastic bottle.
[14] An atmospheric pressure remote plasma CVD apparatus, comprising a dielectric chamber having a gas inlet, an internal space, and a plasma outlet, and a plasma generator which generates plasma in the internal space, wherein the atmospheric pressure remote plasma CVD apparatus is provided with a conductor which can be arranged in, inserted into, and removed from the internal space.
[15] The atmospheric pressure remote plasma CVD apparatus according to [14], wherein the conductor comprises an insulation sheath which extends from the gas inlet of the dielectric chamber.
[16] An atmospheric pressure remote plasma CVD apparatus, comprising a dielectric chamber having a gas inlet, an internal space, and a plasma outlet, and a plasma generator which generates plasma in the internal space, wherein the atmospheric pressure remote plasma CVD apparatus is provided with a raw material supply mechanism for introducing a fluororesin or hydrocarbon thermosetting resin rod-shaped object into the internal space.

### [ADVANTAGEOUS EFFECTS OF INVENTION]

One embodiment of the atmospheric pressure remote plasma CVD apparatus can deliver plasma, the flow velocity of which has been increased by the nozzle, long distances, for example, a distance of several tens of centimeters, from the plasma outlet under atmospheric pressure. Thus, the plasma-excited raw material gas can be delivered to the surfaces of various substrates including substrates having three-dimensional shapes, for example, the inner surfaces of plastic bottles, whereby coatings can be formed on these surfaces under atmospheric pressure.

The above descriptions shall not be deemed to disclose all embodiments of the present invention nor all advantages related to the present invention.

### BRIEF DESCRIPTION OF DRAWINGS

FIG. 1 is a schematic cross-sectional view of an atmospheric pressure remote plasma CVD apparatus according to an embodiment.
FIG. 2 is a schematic cross-sectional view of a dielectric chamber according to an embodiment.
FIG. 3A is a schematic cross-sectional view of an atmospheric pressure remote plasma CVD apparatus according to another embodiment.
FIG. 3B is a schematic cross-sectional view of an atmospheric pressure remote plasma CVD apparatus according to another embodiment.
FIG. 3C is a schematic cross-sectional view of an atmospheric pressure remote plasma CVD apparatus according to another embodiment.
FIG. 4 is a schematic cross-sectional view of an atmospheric pressure remote plasma CVD apparatus according to yet another embodiment.
FIG. 5 is an explanatory diagram showing microwaves the outputs of which are controlled so as to have the shape of a sawtooth wave.

Though a more detailed description will be given below with reference to the drawings in order to exemplify typical embodiments of the present invention, the present invention is not limited to these embodiments. Regarding the reference signs of the drawings, elements designated with identical or corresponding reference signs in different drawings represent the same or corresponding elements.

The atmospheric pressure remote plasma CVD apparatus according to an embodiment comprises a dielectric chamber having a gas inlet, an internal space, and a plasma outlet, and a plasma generator which generates plasma in the internal space. The plasma outlet of the dielectric chamber comprises a nozzle having an opening area smaller than an average cross-sectional area of a cross-section orthogonal to a gas flow direction of the internal space. The average cross-sectional area of a cross-section orthogonal to a gas flow direction of the internal space means the value obtained by averaging the area of the cross-section orthogonal to the gas flow direction from the gas inlet, through the internal space, to the upstream end of the nozzle portion.

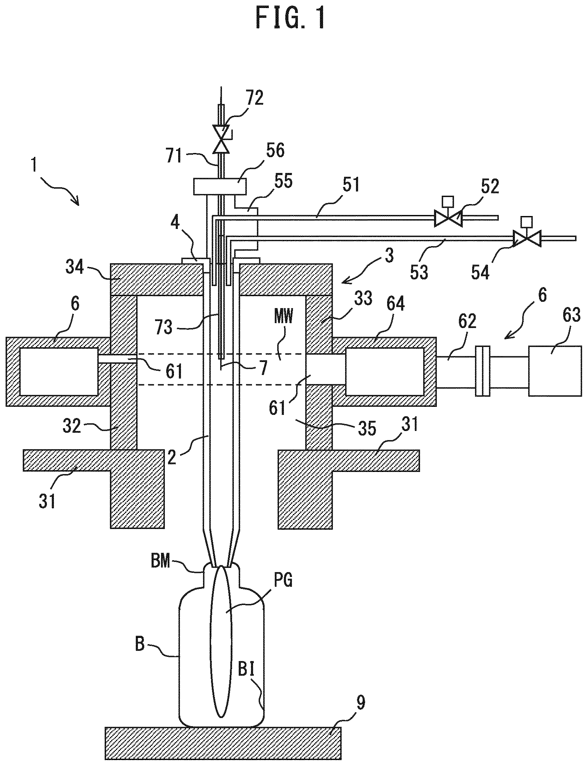

FIG. 1 shows a schematic cross-sectional view of the atmospheric pressure remote plasma CVD apparatus according to an embodiment. The atmospheric pressure remote plasma CVD apparatus 1 comprises a dielectric chamber 2 and a microwave irradiation device as a plasma generator 6. The atmospheric pressure remote plasma CVD apparatus 1 can form a coating, such as a DLC film, on a substrate surface, such as the inner surface BI of a plastic bottle B using, for example, plasma-excited gas PG.

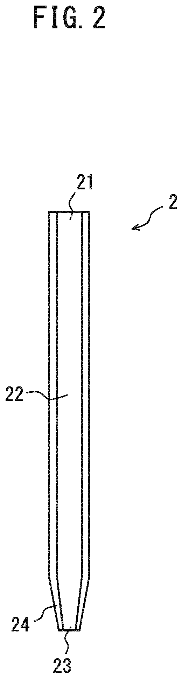

FIG. 2 shows a schematic cross-sectional view of a dielectric chamber according to an embodiment. The dielectric chamber 2 has a gas inlet 21, an internal space 22, and a plasma outlet 23, and the plasma outlet 23 includes a nozzle 24 having an opening area smaller than the average cross-sectional area of a cross-section orthogonal to the gas flow direction of the internal space. The flow velocity of the carrier gas or raw material gas entering from the gas inlet 21 of the dielectric chamber 2 and which has been plasma-excited in the internal space 22 is increased by the nozzle 24, and these plasma-excited gases can be ejected from the plasma outlet 23 and delivered over a long distance, for example, a distance of several tens of centimeters.

The atmospheric pressure remote plasma CVD apparatus 1 comprises an external chamber 3 which is formed substantially entirely in a cylindrical shape and which has a lid 34 arranged on its top surface and side walls 32, 33 composed of a metal material, such as aluminum, which is a conductor, and a microwave confinement chamber 35 is formed inside the external chamber 3. In a bottom part of the external chamber 3, a pedestal 31 composed of a metal material such as aluminum, which is a conductor, is arranged to support the side walls 32, 33, etc., while the center of the pedestal 31 serving as the bottom part is open, and the plasma outlet 23 of the dielectric chamber 2 is arranged so as to project outward through the center of the pedestal 31. In the gap between the dielectric chamber 2 and the pedestal 31, a conductor, such as aluminum, which shields microwaves may be arranged so as to prevent the leakage of microwaves to the outside.

A flange 4 and the dielectric chamber 2 are arranged so as to pass through the lid 34 in substantially the center of the lid 34 constituting the external chamber 3. The flange 4 is formed of, for example, a dielectric, such as a fluororesin or ceramic, is inserted from the upper part of the lid 34 of the external chamber 3, and is affixed to the lid 34. If a metal material is present in the vicinity of the gas inlet 21 of the dielectric chamber 2, abnormal discharge may occur during plasma ignition. By forming the flange 4 from a dielectric material, such abnormal discharge can be prevented. As shown in FIG. 1, the lid 34 fixedly holds the dielectric chamber 2 so that the central axis of the dielectric chamber 2 is aligned on the central axis of the external chamber 3. Thus, the dielectric chamber 2 is arranged so as to pass through the lid 34 of the external chamber 3, and cross the microwave confinement chamber 35, such that the plasma outlet 23 is located outside the microwave confinement chamber 35.

A purge tube (not illustrated) for purging the microwave confinement chamber 35 with nitrogen or an inert gas, such as argon, neon, or helium, may be provided in the lid 34 or the side walls 32, 33 constituting the external chamber 3. By purging the microwave confinement chamber 35 with an inert gas, it is possible to suppress the generation of plasma in a space other than the internal space 22 of the dielectric chamber 2. It is preferable to arrange a shield for microwave confinement in the purge tube.

A blower (not illustrated), a rotary pump, etc., may be arranged around the substrate (plastic bottle B) to discharge excess raw material gas, carrier gas, etc., to the outside. As a result, the surroundings of the substrate may be maintained in a reduced pressure atmosphere, for example, 1,000 to 100,000 Pa (approximately 0.01 atm to approximately 0.99 atm).

A T-shaped pipe 55 for housing a raw material gas supply line 51 and a carrier gas supply line 53, and a lid 56 for covering the upper surface of the T-shaped pipe 55 are arranged in the upper part of the lid 34. The raw material gas supply line 51 is connected to a tank of raw material gas (not illustrated) via a flow control valve 52, and can supply raw material gas to the internal space 22 through the gas inlet 21 of the dielectric chamber 2. The carrier gas supply line 53 is connected to a tank of carrier gas (not illustrated) via a flow control valve 54, and carrier gas can be supplied to the internal space 22 through the gas inlet 21 of the dielectric chamber 2. A plurality of raw material gas supply lines 51 and a plurality of carrier gas supply lines 53 may be arranged in accordance with the types of raw material gas and carrier gas, respectively, or the raw material gas supply line 51 and the carrier gas supply line 53 may be configured to flow a mixed gas of a plurality of raw material gases or carrier gases, respectively. It is preferable to arrange microwave confinement shields in the flange 4, the raw material gas supply line 51, and the carrier gas supply line 53.

The raw material gas supply line 51 can be provided so as to open in an upstream part, middle part, or downstream part of the internal space 22 of the dielectric chamber 2. The position of the aperture of the raw material gas supply line 51 is preferably selected so as to secure time for mixing the carrier gas plasma-excited in the internal space 22 and the raw material gas for efficient plasma excitation of the raw material gas, and minimize particle formation by recombining plasma in the dielectric chamber 2 and film formation on the inner wall surface of the dielectric chamber 2. By mixing the carrier gas plasma-excited in the dielectric chamber 2 and the raw material gas, the amount of plasma-excited gas that is inactivated before being supplied to the substrate surface can be reduced. As a result, a high-concentration plasma-excited gas can be supplied to the substrate surface to improve the film forming speed and the quality of coating. In addition, a part of the raw material gas can be plasma-excited not by the plasma-excited carrier gas but by direct irradiation of microwaves, which also contributes to an increase in the concentration of plasma-excited gas. The upstream part of the internal space 22 means a space corresponding to 10 to 20% of the volume of the internal space 22 along the gas flow direction of the internal space 22 from the gas inlet 21, the downstream part of the internal space 22 means a space corresponding to 5 to 20% of the volume of the internal space 22 along the direction opposite to the gas flow direction of the internal space 22 from the plasma outlet 23, and the middle part of the internal space 22 means the space other than the upstream part and the downstream part of the internal space 22.

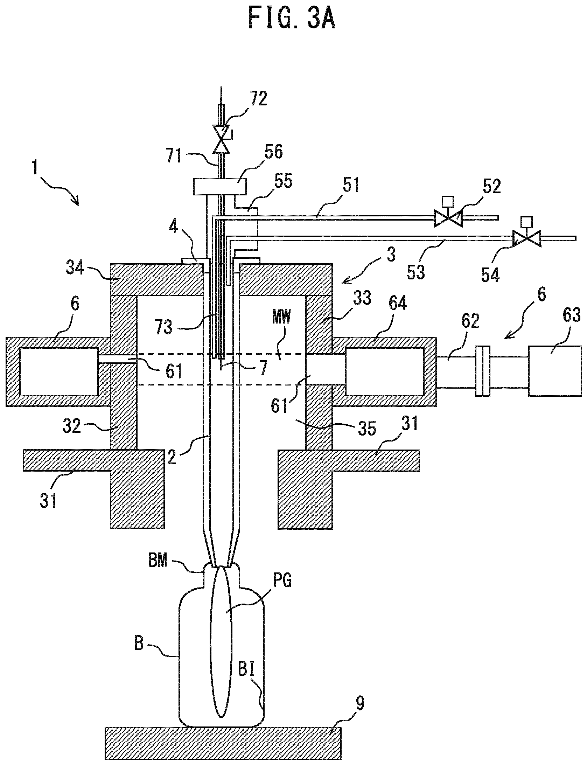

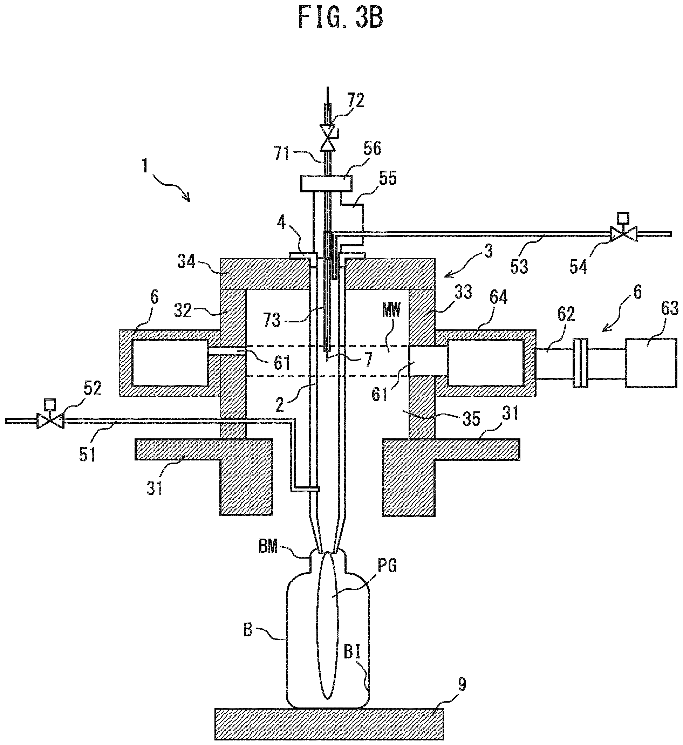

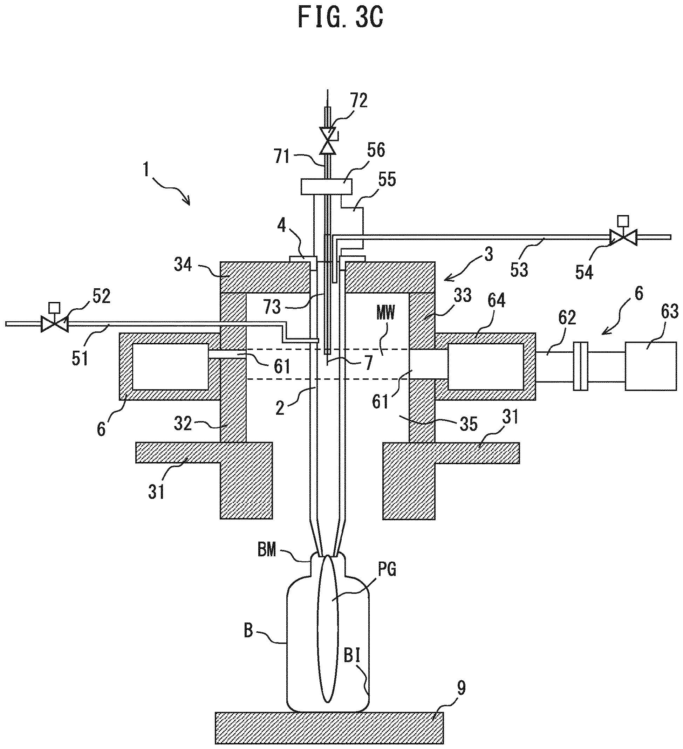

The raw material gas supply line 51 may be open between the gas inlet 21 of the dielectric chamber 2 and the internal space 22 of the dielectric chamber 2, or may be open through a side part of the dielectric chamber 2 and in the internal space 22 of the dielectric chamber 2. In FIG. 1, the raw material gas supply line 51 is provided so as to enter from the gas inlet 21 and open at the upstream part of the internal space 22 of the dielectric chamber 2. FIG. 3A is a schematic cross-sectional view of the atmospheric pressure remote plasma CVD apparatus of another embodiment, and here, the raw material gas supply line 51 is provided so as to enter from the gas inlet 21 and open in the middle part of the internal space 22 of the dielectric chamber 2, for example, a microwave supply region MW. FIG. 3B is a schematic cross-sectional view of the atmospheric pressure remote plasma CVD apparatus according to another embodiment, and here, the raw material gas supply line 51 is provided so as to enter the microwave confinement chamber 35 through the side wall 32 in the lateral direction, further pass through a side part of the dielectric chamber 2, and open at the downstream part of the internal space 22 of the dielectric chamber 2. FIG. 3C is a schematic cross-sectional view of the atmospheric pressure remote plasma CVD apparatus of another embodiment, and here, the raw material gas supply line 51 is provided so as to enter the microwave confinement chamber 35 through the side wall 32 in the lateral direction, further pass through a side part of the dielectric chamber 2, and open in the middle part of the internal space 22 of the dielectric chamber 2 and upstream of the microwave supply region MW. In FIGS. 1, 3A, 3B and 3C, the microwave supply region MW is indicated as a region surrounded by two parallel dotted lines defined by the upper and lower ends of slit antennas 61. The opening position of the raw material gas supply line 51 is preferably upstream of the microwave supply region MW.

The opening position of the carrier gas supply line 53 may be any position as long as it is upstream of the microwave supply region MW.

The plasma generator 6 shown in FIG. 1 is a microwave irradiation device. The microwave irradiation device can efficiently generate high-density plasma in the internal space 22 of the dielectric chamber 2, and can lengthen the delivery distance of the plasma-excited gas from the plasma outlet. An annular resonator 64 is provided around the microwave confinement chamber 35 of the external chamber 3 as a microwave introduction means. The annular resonator 64 is formed by a waveguide having a substantially rectangular cross section in an endless annular shape.

A plurality of slit antennas 61 (elongate grooves) extending in the radial direction are formed in the surface of the annular resonator 64 on the microwave confinement chamber 35 side (the side which faces the dielectric chamber 2 arranged in the microwave confinement chamber 35) and in the side walls 32, 33 so that they are separated in the circumferential direction, and microwaves are introduced into the microwave confinement chamber 35 from the slit antennas 61 (also referred to as "slot antennas", "slits" or "slots"; in the present disclosure, they may be simply referred to as "slits 61"). In the atmospheric pressure remote plasma CVD apparatus 1 according to an embodiment, microwaves are introduced from the circumferential direction from the annular resonator 64 in this manner via the slits 61, whereby cylindrical three-dimensional plasma can be formed by surface wave plasma, and high-density plasma can be maintained in the internal space 22 of the dielectric chamber 2 even in an atmospheric pressure state. A microwave oscillator 63 is connected to the outer peripheral surface of the annular resonator 64 via a propagation waveguide 62, and the microwave oscillator 63 supplies microwaves to the annular resonator 64.

The shapes of the slits 61 formed in the annular resonator 64 are not particularly limited, and may be, for example, elongated rectangles, squares, circles, or ellipses. Though the slits 61 are generally formed as a horizontal slit extending parallel to the circumferential direction of the annular resonator 64 or a vertical slit extending perpendicular to the circumferential direction of the annular resonator 64, they may be formed so as to have a random direction without any particular directionality. Since microwaves can be uniformly introduced into the microwave confinement chamber 35, it is preferable that the slits 61 be formed around the annular resonator 64 at equal intervals. In an embodiment in which the dielectric chamber 2 is cylindrical, the shapes of the slits 61 are preferably annular shapes continuously extending in the circumferential direction of the annular resonator 64.

The rated output of the microwave irradiation device 6 can appropriately be determined in accordance with the size and shape of the substrate, the film thickness and area of the coating to be formed, the types and flow rates of the carrier gas and the raw material gas used, and the required production rate. The rated output of the microwave irradiation device 6 can be, for example, 400 W to 6,000 W, 800 W to 3,000 W, or 1,000 W to 2,000 W.

The shape and dimensions of the dielectric chamber 2 may vary, and can be designed according to, for example, the size and shape of the atmospheric pressure remote plasma CVD apparatus 1 and the constituent elements thereof, and in particular, the size and shape of the microwave confinement chamber 35.

The average cross-sectional area of a cross-section orthogonal to the gas flow direction of the internal space of the dielectric chamber 2 can be, for example, 50 mm² to 1,000 mm².

The opening area of the nozzle 24 provided in the plasma outlet 23 of the dielectric chamber 2 is designed to be smaller than the average cross-sectional area of the cross-section orthogonal to the gas flow direction of the internal space of the dielectric chamber 2. The opening area of the nozzle 24 is designed so that the desired flow velocity and spread of the plasma-excited gas can be obtained in accordance with the size of the substrate surface on which the coating is formed, the distance between the nozzle 24 and the substrate surface, the orientation of the substrate surface with respect to the nozzle 24, etc. The opening area of the nozzle 24 can be, for example, 5 mm² to 100 mm², preferably 8 mm² to 50 mm².

In an embodiment, the opening area of the nozzle 24 is 0.01 to 0.1 times, preferably 0.02 to 0.08 times, and more preferably 0.04 to 0.07 times the average cross-sectional area of the cross-section orthogonal to the gas flow direction of the internal space. By making the opening area of the nozzle 24 0.01 to 0.1 times the average cross-sectional area of the cross-section orthogonal to the gas flow direction of the internal space, the plasma-excited gas can be delivered from the plasma outlet 23 to a further distance by increasing the flow velocity of the plasma-excited gas by the nozzle 24.

As shown in FIG. 2, the internal cross-sectional shape of the nozzle 24 may be a straight tapered shape or a tapered shape including curved lines.

The volume of the internal space 22 of the dielectric chamber 2 can be, for example, 20 cm³ to 600 cm³, preferably 30 cm³ to 300 cm³, and more preferably 30 cm³ to 200 cm³.

In an embodiment, the volume of the internal space 22 of the dielectric chamber 2 is determined in accordance with the output of the plasma generator 6. For example, when the plasma generator 6 is a microwave irradiation device, the ratio (P/W) of the output P (W) of the microwave irradiation device to the volume V (cm³) of the internal space 22 is preferably 5 W/cm³ to 30 W/cm³, more preferably 10 W/cm³ to 25 W/cm³, and further preferably 15 W/cm³ to 20 W/cm³. By setting P/W to 5 W/cm³ to 30 W/cm³, high-density plasma can be efficiently generated in the internal space 22 of the dielectric chamber 2, and the plasma-excited gas can be delivered to a further distance from the plasma outlet 23.

In an embodiment, as shown in FIG. 2, it is preferable that the dielectric chamber 2 have a cylindrical shape, and the gas inlet 21 be arranged at one end of the dielectric chamber 2 and the plasma outlet 23 be arranged at the other end of the dielectric chamber 2 in the longitudinal direction of the dielectric chamber 2. By making the dielectric chamber 2 cylindrical and arranging the gas inlet 21 and plasma outlet 23 at opposite ends thereof, the raw material gas and the carrier gas can pass through the internal space 22 of the dielectric chamber 2 in a straight line, whereby the plasma-excited gas can efficiently be ejected from the plasma outlet 23. The dielectric chamber 2 may have a cylindrical shape or a square tubular shape. The dielectric chamber 2 which has a cylindrical shape enables the raw material gas and the carrier gas passing through the internal space 22 as well as these plasma-excited gas to pass therethrough more smoothly, whereby adhesion of reactants of the raw material gas to the inner wall of the dielectric chamber 2 can also be reduced.

The axial length of the tubular dielectric chamber 2 may vary depending on the sizes of the atmospheric pressure remote plasma CVD apparatus 1 and the microwave confinement chamber 35, and can be, for example, 150 mm to 500 mm, preferably 200 mm to 400 mm, and more preferably 200 mm to 360 mm.

In an embodiment, the axial length of the tubular dielectric chamber 2 is determined so that the distance between the plasma outlet 23 protruding from the microwave confinement chamber 35 and the boundary of the microwave confinement chamber 35 is 0 mm to 30 mm, preferably 0 mm to 20 mm, and more preferably 10 mm to 20 mm. In the case in which the plasma outlet 23 is a nozzle tip and the inner surface BI of the plastic bottle B is to be treated, the coating can be formed more uniformly on the inner surface BI by inserting the plasma outlet 23 by 10 to 20 mm into the mouth BM of the plastic bottle B from the top surface.

In an embodiment, the axial length of the tubular dielectric chamber 2 is determined so that the length of the portion of the dielectric chamber 2 located inside the microwave confinement chamber 35 is 60% to 90%, preferably 70% to 90%, and more preferably 80% to 90% of the total length of the dielectric chamber 2.

The outer diameter of the tubular dielectric chamber 2 can be, for example, 15 mm to 60 mm, preferably 20 mm to 50 mm, and more preferably 20 mm to 40 mm. By setting the outer diameter of the tubular dielectric chamber 2 to 15 mm to 60 mm, the carrier gas or raw material gas can be plasma-excited more uniformly in the internal space 22 of the dielectric chamber 2, and the supply rate of the plasma-excited gas to the substrate surface can be increased.

The thickness of the tubular dielectric chamber 2 can be, for example, 1 mm to 6 mm, preferably 2 mm to 5 mm, and more preferably 2 mm to 4 mm. By setting the thickness of the tubular dielectric chamber 2 to 1 mm to 6 mm, the plasma generation efficiency in the internal space 22 of the dielectric chamber 2 can be increased.

The dielectric chamber 2 may have a plurality of plasma outlets 23, and the total opening area of the nozzles 24 provided in the plurality of plasma outlets 23 is smaller than the average cross-sectional area of the cross-section orthogonal to the gas flow direction of the internal space. As a result, the plasma-excited gas can be ejected in a plurality of directions, and the coating can be uniformly formed on the surface of the substrate, which has a three-dimensional shape.

The dielectric chamber 2 can be formed from glass, such as soda lime glass and borosilicate glass, ceramics, such as alumina and zirconia, quartz, or heat-resistant resin materials, such as a fluororesin and polyimide. The dielectric chamber 2 preferably comprises at least one selected from the group consisting of glass, quartz, and a fluororesin, and the use of quartz is more preferable because plasma can be efficiently generated due to the low microwave absorption thereof. The dielectric chamber can be formed by a known method, such as a firing method, a cutting method, an injection molding method, an extrusion molding method, or a compression molding method, depending on the type of material.

The nozzle 24 may be integrally formed as a part of the dielectric chamber 2, or may be formed separately from the rest of the dielectric chamber 2 and affixed to the rest of the dielectric chamber 2 by screwing, gluing, clamping, etc. By forming the nozzle 24 separately from the rest of the dielectric chamber 2, the nozzle 24 can be exchanged in accordance with the substrate to be coated. The material of the nozzle 24 may be the same as or different from the material of the rest of the dielectric chamber 2. For example, the nozzle 24 can be made of highly processable alumina and the rest of the dielectric chamber 2 can be made of quartz glass.

The atmospheric pressure remote plasma CVD apparatus 1 may further comprise a conductor 7 which can be arranged in, inserted into, and removed from the internal space 22 of the dielectric chamber 2. When microwaves are supplied to the microwave confinement chamber 35 in a state in which the conductor 7 is inserted in the internal space 22 of the dielectric chamber 2, the microwaves transmitted through the dielectric chamber 2 cause discharge from the conductor 7. As a result, plasma of the carrier gas or raw material gas can become ignited. This can facilitate plasma generation in the internal space 22 of the dielectric chamber 2. By removing the conductor 7 from the internal space 22, it is possible to prevent or suppress the generation of impurities derived from the conductor 7 (for example, tungsten particles) and the adhesion of such impurities to the substrate.

Once plasma has been generated in the internal space 22 of the dielectric chamber 2, since the conductor 7 is not required for plasma excitation of the carrier gas and raw material gas, the plasma can be ignited by injecting plasma of an inert gas from the upper part of the dielectric chamber 2 by means other than the conductor 7, for example, using a plasma torch using a high voltage pulse and introducing it into the internal space 22.

It is preferable that the conductor 7 be inserted through the gas inlet 21 of the dielectric chamber 2, ignite the plasma, and then be removed from the gas inlet 21. The conductor 7 can be inserted into the internal space 22 of the dielectric chamber 2 from the upper part of the lid 56 through the T-shaped pipe 55 and the gas inlet 21 of the dielectric chamber 2, as shown in, for example, FIG. 1. In FIG. 1, the conductor 7 is held by a guide 71 so as to be coaxial with the central axis of the dielectric chamber 2, and a cock valve 72 is provided in the middle of the guide 71 to prevent gas from communicating between the internal space 22 of the dielectric chamber 2 and the outside of the lid 56 after the conductor 7 has been removed. In place of or in addition to the cock valve 72, a lid (not illustrated) composed of a resin, such as a fluororesin or polyimide, may be provided on the outside of the gas inlet 21 of the dielectric chamber 2 so as to cut off the communication of gas between the internal space 22 of the dielectric chamber 2 and the outside of the lid after the conductor 7 has been removed.

The conductor 7 may be placed in the dielectric chamber 2. When the conductor 7 is placed, for example, a short needle-shaped conductor 7 may be pierced through and affixed to the side part of the dielectric chamber 2, preferably in the microwave supply region MW, so as to be orthogonal to the gas flow.

The conductor 7 may comprise an insulation sheath 73 extending from the gas inlet 21 of the dielectric chamber 2. The insulation sheath 73 can be formed from glass, such as soda lime glass or borosilicate glass, a ceramic, such as alumina or zirconia, quartz, or a heat-resistant resin material, such as a fluororesin or polyimide. By providing the insulation sheath 73, the exposed area of the conductor 7 can be controlled and the microwaves can be concentrated on the exposed portion of the conductor 7 to promote discharge and suppress abnormal discharge, whereby the plasma can be ignited more reliably.

The conductor 7 is preferably made of a metal material, and can be composed of, for example, a metal material, such as tungsten, stainless steel, or platinum. The conductor 7 is preferably made of tungsten, which has excellent heat resistance and durability. The conductor 7 can be formed by a known method, such as a firing method or a cutting method, depending on the type of material thereof.

When the dielectric chamber 2 is tubular, it is preferable that the conductor 7 be needle-shaped and be capable of moving along the central axis of the dielectric chamber 2.

The tip of the conductor 7 may be flat or may be sharp. By sharpening the tip of the conductor 7, microwaves can be concentrated on the tip to promote discharge and suppress abnormal discharge, whereby the plasma can be ignited more reliably.

The dimensions of the conductor 7 when the conductor 7 is inserted and removed without being placed in the dielectric chamber 2 can be appropriately determined depending on the size and shape of the dielectric chamber 2, and the sizes of the microwave confinement chamber 35, the microwave supply region MW, etc. When the dielectric chamber 2 is tubular, the length of the portion of the conductor 7 exposed to the internal space 22 when the conductor 7 is inserted into the internal space 22 of the dielectric chamber 2 through or without the insulation sheath 73 is preferably 5 mm to 200 mm. The outer diameter of the conductor 7 is preferably 1 mm to 5 mm, and more preferably 1 mm to 3 mm.

The conductor 7 preferably extends to at least a part of the microwave supply region MW. Since the conductor 7 extends to at least a part of the microwave supply region MW, plasma ignition of the carrier gas or the raw material gas can be performed more effectively, and the conductor 7 can be easily removed. From the viewpoint of the removability of conductor 7, it is preferable that the conductor 7 do not extend further downstream beyond the microwave supply region MW.

In an embodiment, the conductor described above can also be provided in an atmospheric pressure remote plasma CVD apparatus comprising a dielectric chamber having a gas inlet, an internal space, and a plasma outlet, and a plasma generator for generating plasma in the internal space. The conductor may comprise the aforementioned insulation sheath extending from the gas inlet of the dielectric chamber. In the atmospheric pressure remote plasma CVD apparatus of this embodiment, the dielectric chamber does not have a nozzle, and the gas plasma-excited in the internal space is discharged from the plasma outlet and forms a coating on the surface of the substrate placed near the plasma outlet. The surface of the substrate may be arranged so as to surround the plasma outlet and a part of the dielectric chamber. For example, the dielectric chamber may be inserted from the opening of the plastic bottle, and the plasma outlet and a part of the dielectric chamber may be surrounded by the inner surface of the plastic bottle. In this embodiment, the plasma outlet of the dielectric chamber may be located inside the microwave supply region or outside the microwave supply region. By arranging the plasma outlet of the dielectric chamber within the microwave supply region, microwave energy can be continuously applied to the plasma-excited gas emitted from the plasma outlet to maintain the activity of the plasma-excited gas for a longer period of time. The other components of the atmospheric pressure remote plasma CVD apparatus are as described above.

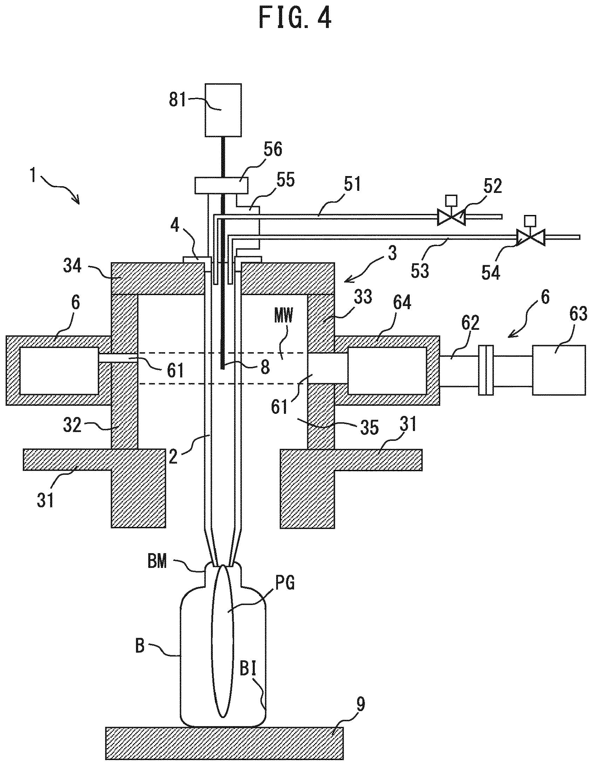

FIG. 4 shows a schematic cross-sectional view of an atmospheric pressure remote plasma CVD apparatus according to yet another embodiment. The atmospheric pressure remote plasma CVD apparatus 1 may further comprise a raw material supply mechanism 81 for introducing a rod-shaped object 8 of a fluororesin or a hydrocarbon-based thermosetting resin into the internal space 22. Without being bound by theory, it is considered that the energy when the rod-shaped object 8 of the fluororesin or hydrocarbon-based thermosetting resin is decomposed by heat assists the plasma excitation of the carrier gas or the raw material gas and can increase plasma generation efficiency. Though the conductor 7 is not illustrated in FIG. 4, the atmospheric pressure remote plasma CVD apparatus 1 of this embodiment may further comprise the conductor 7. When the insulation sheath 73 of the conductor 7 is formed of a fluororesin or a hydrocarbon-based thermosetting resin, it can also function as the rod-shaped object 8.

The rod-shaped object 8 can be introduced into the internal space 22 through the gas inlet 21 of the dielectric chamber 2. As shown in FIG. 4, for example, the rod-shaped object 8 can be introduced from the upper part of the lid 56 into the internal space 22 of the dielectric chamber 2 through the T-shaped pipe 55 and the gas inlet 21 of the dielectric chamber 2. It is preferable to seal between the lid 56 and the rod-shaped object 8 to block the communication of gas between the internal space 22 of the dielectric chamber 2 and the outside of the lid 56.

The rod-shaped object 8 is formed of a fluororesin or a hydrocarbon-based thermosetting resin. Examples of fluororesins include polytetrafluoroethylene and polyvinylidene fluoride. Examples of hydrocarbon-based thermosetting resins include phenol resins and unsaturated polyester resins. The rod-shaped object 8 can be formed by a known method, such as an extrusion method or a cutting method, depending on the type of material.

Since the rod-shaped object 8 is gradually consumed as the plasma is generated, it is preferable to replenish the rod-shaped object 8 with the raw material supply mechanism 81 so that a certain amount thereof is present in the internal space 22 of the dielectric chamber 2. Examples of the raw material supply mechanism 81 include a mechanism in which a polytetrafluoroethylene rod-shaped object 8 is unwound from a roll and continuously introduced into the dielectric chamber 2.

The dimensions of the rod-shaped object 8 can be appropriately determined in accordance with the size of the internal space 22 of the dielectric chamber 2. It is preferable to continuously supply the rod-shaped object 8 into the dielectric chamber 2 as the rod-shaped object 8 is consumed. It is preferable that the length of the portion of the rod-shaped object 8 present in the internal space 22 extend to at least a part of the microwave supply region MW. The outer diameter of the rod-shaped object 8 is preferably 0.5 mm to 5 mm, and more preferably 1 mm to 2 mm.

In an embodiment, the raw material supply mechanism for introducing the fluororesin or hydrocarbon-based thermosetting resin rod-shaped object described above can be provided in an atmospheric pressure remote plasma CVD apparatus comprising a dielectric chamber having a gas inlet, an internal space, and a plasma outlet, and a plasma generator for generating plasma in the internal space. In the atmospheric pressure remote plasma CVD apparatus of this embodiment, the dielectric chamber does not have a nozzle, and the gas plasma-excited in the internal space is discharged from the plasma outlet and forms a coating on the surface of the substrate placed near the plasma outlet. The surface of the substrate may be arranged so as to surround the plasma outlet and a part of the dielectric chamber. For example, the dielectric chamber may be inserted from the opening of the plastic bottle, and the plasma outlet and a part of the dielectric chamber may be surrounded by the inner surface of the plastic bottle. In this embodiment, the plasma outlet of the dielectric chamber may be located inside the microwave supply region or outside the microwave supply region. By arranging the plasma outlet of the dielectric chamber within the microwave supply region, microwave energy can be continuously applied to the plasma-excited gas emitted from the plasma outlet to maintain the activity of the plasma-excited gas for a longer period of time. The other components of the atmospheric pressure remote plasma CVD apparatus are as described above.

As shown in FIG. 1, a conductor 9 to which a negative voltage can be applied may be arranged downstream of the plasma outlet 23, and a substrate, for example, a plastic bottle B, may be arranged between the plasma outlet 23 and the conductor 9. Since the conductor 9 attracts the ions of the ionized raw material gas, the film formation rate can be increased and the coating can be stably formed on the substrate. Examples of the conductor 9 include conductive metals, such as copper, silver, and aluminum, and carbon. Since the ions of the ionized raw material gas can be more effectively attracted to the substrate, it is preferable that the conductor 9 be grounded, and it is more preferable that a negative voltage of 500 to 2,000 V be applied thereto. The conductor 9 may be used as the stage or carrier of the substrate.

In another embodiment, a tubular member which has a wall surface substantially parallel to the side walls 32, 33 of the external chamber 3 and which is composed of a material through which microwaves can pass, may be arranged in the interior of the external chamber 3, and the interior of the tubular member may serve as the microwave confinement chamber 35. In this embodiment, the tubular member surrounds the dielectric chamber 2 along the axial direction of the dielectric chamber 2. An example of the tubular member includes a quartz tube.

In another embodiment, a mixed gas of the raw material gas and the carrier gas may be supplied to the internal space 22 through the gas inlet 21 of the dielectric chamber 2 through a single supply line.

In another embodiment, as the plasma generator, a single-mode waveguide can be connected to a microwave generator, and the dielectric chamber 2 can be provided so as to be orthogonal to the microwave propagation direction of the waveguide. In yet another embodiment, in place of the microwave irradiation device, a known plasma generator which is capable of producing low temperature plasma under atmospheric pressure can be used. An example of such a plasma generator includes a high frequency plasma generator. As the high frequency plasma generator, for example, a high frequency power source capable of applying a high frequency pulse of 1 to 10 kHz can be used. The waveform of the pulse is not particularly limited, but the application of a periodic pulse voltage with a steep voltage change is advantageous for efficient generation of plasma.

The atmospheric pressure remote plasma CVD apparatus 1 described above can be used to form a coating on the surface of the substrate. An embodiment provides a method for forming a coating on a surface of a substrate, and the method comprises providing the atmospheric pressure remote plasma CVD apparatus 1, arranging a substrate downstream of the plasma outlet 23, introducing a carrier gas from the gas inlet 21, turning the carrier gas into a plasma in the internal space 22, introducing a raw material gas from the gas inlet 21, mixing the raw material gas and the plasma-excited carrier gas to generate a plasma-excited raw material gas, and ejecting the plasma-excited raw material gas from the plasma outlet 23 toward the substrate to form a coating on the surface of the substrate.

The substrate may contain a non-metallic material, a metallic material, or a polymeric material. The coating formation method of the present disclosure can be suitably applied to substrates containing a polymer material having low heat resistance. Examples of such polymer materials include resins including polyesters, such as polyethylene terephthalate (PET), polybutylene terephthalate (PBT), and polyethylene naphthalate (PEN); polyolefins, such as low-density polyethylene, high-density polyethylene, polypropylene, poly(1-butene), poly(4-methyl-1-pentene), or random or block copolymers of α-olefins, such as ethylene, propylene, 1-butene, and 4-methyl-1-pentene; ethylene-vinyl compound copolymers, such as ethylene-vinyl acetate copolymers, ethylene-vinyl alcohol copolymers, and ethylene-vinyl chloride copolymers; styrene-based resins, such as polystyrene, acrylonitrile-styrene copolymers, acrylonitrile-butadienestyrene (ABS) copolymers, and α-methylstyrene-styrene copolymers; polyvinyl chloride; polyvinylidene chloride; vinyl chloride-vinylidene chloride copolymers; acrylic resins, such as poly(methyl acrylate) and poly(methyl methacrylate); polyamides, such as nylon 6, nylon 6/6, nylon 6/10, nylon 11, and nylon 12; polycarbonate; polyphenylene oxide; and polyhydroxy alkanoate. These resins may be used alone or in combination of two or more thereof.

The substrate may have either a planar shape or a three-dimensional shape. Examples of the substrate include articles having a planar shape, such as films and tapes, and articles having a three-dimensional shape, such as bottles, caps, and cups.

In an embodiment, the substrate is a plastic bottle, and a coating is formed on the inner surface thereof. The shape of the plastic bottle is not particularly limited, and the body portion, which is generally used as a beverage bottle, may have an axisymmetric shape (for example, a circular shape in a cross-sectional view) or an asymmetrical shape.

The substrate is arranged downstream of the plasma outlet 23. It is preferable to align the substrate so that the portion of the substrate surface on which the coating is to be formed substantially faces the direction in which the plasma-excited raw material gas is ejected.

In the case of a plastic bottle, the long axis of the plastic bottle and the direction in which the plasma-excited raw material gas is ejected are arranged so as to be approximately the same. The plastic bottle may be placed on a stage comprising a rotation mechanism, and the plastic bottle may be rotated around its long axis direction during film formation. This makes it possible to form a more uniform coating on the inner surface of the plastic bottle.

As the carrier gas, nitrogen and an inert gas, such as argon, helium, or neon, can be used.

The flow rate of the carrier gas can be determined in consideration of the volume of the internal space 22 of the dielectric chamber 2, the average cross-sectional area of the cross-section orthogonal to the gas flow direction of the internal space, the opening area of the nozzle 24 provided in the plasma outlet 23, and the film formation speed. The flow rate of the carrier gas can be, for example, 500 sccm to 500,000 sccm, preferably 600 sccm to 10,000 sccm, and more preferably 1,000 sccm to 6,000 sccm.

In an embodiment, the flow rate Fc of the carrier gas is determined so as to be 500 ~ 5,000 × S [sccm] when the opening area of the nozzle 24 of the dielectric chamber 2 is defined as S [cm²]. In another embodiment, the flow rate Fc of the carrier gas is determined so as to be 5,000 ~ 20,000 × S [sccm] when the opening area of the nozzle 24 of the dielectric chamber 2 is defined as S [cm²].

As the raw material gas, various raw material gases can be used depending on purpose. Hydrocarbons, such as acetylene, ethylene, methane, and ethane, can be used to form a carbon film. Silicon compounds, such as silicon tetrachloride, silanes, organic silane compounds, and organic siloxane compounds, and if necessary, oxygen gas, air, or the like can be used to form a silicon oxide film. The raw material gas can be used alone or in combination of two or more, depending on the chemical composition of the coating to be formed.

The flow rate of the raw material gas can be determined in consideration of the volume of the internal space 22 of the dielectric chamber 2, the average cross-sectional area of the cross-section orthogonal to the gas flow direction of the internal space, the opening area of the nozzle 24 provided in the plasma outlet 23, the surface area of the substrate to be treated, the type of the raw material gas, and the film formation speed. The flow rate of the raw material gas can be, for example, 2 sccm to 100 sccm, preferably 5 sccm to 50 sccm, and more preferably 5 sccm to 30 sccm. For example, in the coating formation on the inner surface of a plastic bottle (350 mL), it can be 5 sccm to 40 sccm, preferably 5 sccm to 30 sccm, and more preferably 5 sccm to 20 sccm per bottle.

In an embodiment, the flow rate Fs of the raw material gas is determined so as to be 2 ~ 10 × S [sccm] when the opening area of the nozzle 24 of the dielectric chamber 2 is defined as S [cm²]. In another embodiment, the flow rate Fs of the raw material gas is determined so as to be 50 ~ 200 × S [sccm] when the opening area of the nozzle 24 of the dielectric chamber 2 is defined as S [cm²].

As other gases, gases such as oxygen and hydrogen may be mixed with the carrier gas or the raw material gas.

When a microwave irradiation device is used as the plasma generator 6, after the internal space 22 of the dielectric chamber 2 is filled with the carrier gas, or the carrier gas and the raw material gas, microwaves at a high frequency of, for example, 2.45 GHz are oscillated in the microwave oscillator 63. The microwaves supplied from the microwave oscillator 63 propagate through the propagation waveguide 62, are supplied to the interior of the annular resonator 64, pass through the slits 61, and are introduced into the microwave confinement chamber 35, whereby plasma of the carrier gas is generated in the internal space 22 of the dielectric chamber 2. The microwaves propagating inside the annular resonator 64 as a traveling wave are introduced into the microwave confinement chamber 35 of the external chamber 3 from a plurality of slits 61 formed in the annular resonator 64 and emitted.

Since the microwaves propagating inside the annular resonator 64 are not a standing wave but a traveling wave which rotates inside the endless annular resonator 64, the electromagnetic field emitted from the slits 61 is uniform in the circumferential direction of the annular resonator 64. The microwaves emitted from the annular resonator 64 via the slits 61 in a 360-degree direction form a cylindrical three-dimensional plasma by the surface wave plasma, whereby it becomes easier to maintain the plasma in the internal space 22 of the dielectric chamber 2 under atmospheric pressure, and plasma (surface wave plasma) having high uniformity is generated in the internal space of the dielectric chamber 2.

As the frequency of the microwaves supplied from the microwave oscillator 63 to the annular resonator 64, for example, any frequency in the range of 300 MHz to 100 GHz can be selected. The microwave frequency is preferably 2.45 GHz, 5.8 GHz, or 22.125 GHz, which are permitted for industrial use.

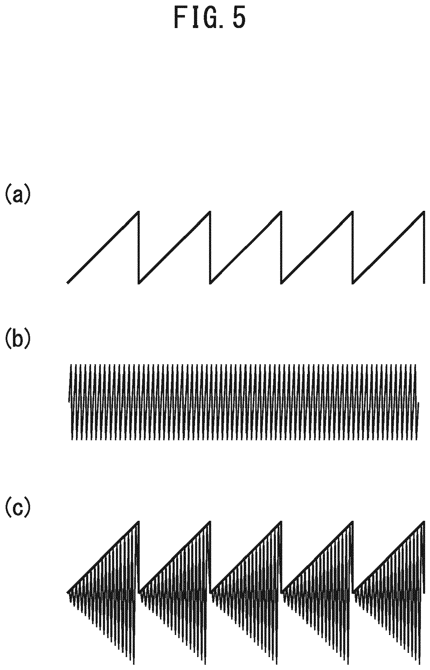

The microwave output may be modulated to be turned on and off by a square wave in the range of 10 Hz to 5,000 Hz. As a result, the temperature of the plasma-excited gas in the dielectric chamber 2 can be lowered as compared with the case where microwaves are constantly and continuously irradiated, whereby the temperature of the plasma-excited gas to be ejected can be lowered and thermal deformation of the substrate can be prevented. The frequency of the square wave to be selected is selected so that the plasma oscillation can be maintained and the decomposition activation of the raw material gas is efficiently maintained. At this time, the ratio of the ON time in one cycle is called the duty ratio, and this duty ratio may be changed from 1 to approximately 0.1. The modulation output of the square wave of the microwaves may be further superimposed and modulated to vary from 0 to 100% in the shape of the sawtooth wave. FIG. 5 is an explanatory diagram showing microwaves the outputs of which are controlled so as to have the shape of a sawtooth wave, (a) represents a steady microwave output, (b) represents an output control signal of a sawtooth wave, and (c) represents microwaves the outputs of which are controlled so as to have the shape of a sawtooth wave. Regarding the pulsed output of microwave consisting of a sawtooth waveform (sawtooth wave shape) in which the output tilting and rising and returning to output 0 from the highest point is repeated, by repeating ON and OFF of the microwave output, plasma generation and extinction will be repeated. When microwaves the outputs of which are controlled in the shape of a sawtooth wave are used, an increase in plasma temperature can be suppressed as compared with microwaves having a continuous output, and the activity of the plasma can be appropriately maintained. As a result, the temperature rise of the plasma-excited gas is suppressed, and surface treatment can be performed for longer periods of time. This is advantageous in increasing the thickness of the coating formed on the substrate surface having low heat resistance.

By making the microwave output a pulse-shaped sawtooth wave, in some cases, active species in the plasma (oxygen ions, oxygen radicals, hydrocarbon ions, hydrocarbon radicals, carbon ions, hydrogen radicals, etc.) lose energy and become particles in space when the microwave output instantly becomes zero. By repeatedly increasing the output by inclining from the zero-level output and maintaining the active state of plasma again, even in the plasma state in the atmospheric pressure region (0.01 to 1 atm), coating can be formed in a state in which recombined particles are unlikely to be generated while maintaining a relatively low plasma gas temperature (approximately several hundred K). The pulse frequency of the sawtooth wave is preferably 500 Hz to 5,000 Hz. For example, by connecting a sawtooth-shaped pulse signal generated by a function generator or the like to the output regulator of the magnetron tube inside the microwave oscillator 63 and performing pulse modulation, the microwave output can be in the shape of a pulsed sawtooth wave.

The microwave output can be appropriately determined depending on the reach of the plasma-excited raw material gas, the surface area of the substrate to be treated, the thickness of the coating, the type of the raw material gas, etc. The microwave output can be, for example, 50 to 5,000 W, and preferably 100 to 3,000 W, per general plastic bottle having a capacity of 500 mL.

When the plasma is generated in the internal space 22 of the dielectric chamber 2, the conductor 7 may be inserted into the internal space 22 of the dielectric chamber 2 to promote the ignition of the plasma. In the internal space 22 of the dielectric chamber 2, the conductor 7 inserted from the gas inlet 21 of the dielectric chamber 2 serves as an electrode, sparks are generated by the discharge of microwaves, and the ignition of plasma is easily generated. The excitation state of the plasma once generated is maintained by microwaves. After the plasma is ignited, it is preferable to remove the conductor 7 from the gas inlet 21. By removing the conductor 7 from the internal space 22, it is possible to prevent or suppress the generation of impurities derived from the conductor 7 (for example, tungsten particles) and the adhesion of such impurities to the substrate. Only the carrier gas may be supplied to the dielectric chamber 2, and the raw material gas may be supplied after the plasma-excited carrier gas is generated by the ignition using the conductor 7. By generating the plasma-excited carrier gas in advance in the internal space 22 of the dielectric chamber 2, plasma excitation of the raw material gas can be performed more efficiently, and a higher density plasma-excited raw material gas can be ejected from the plasma outlet 23.

The supply of the raw material gas may be started at the same time as the supply of the carrier gas, or may be started after the carrier gas is plasma-excited. The raw material gas may be supplied after being mixed with the carrier gas, or the raw material gas and the carrier gas may be supplied separately.

The raw material gas is mixed with the plasma-excited carrier gas in the internal space 22 of the dielectric chamber 2 to generate the plasma-excited raw material gas. Some of the raw material gas may be plasma-excited by direct microwave irradiation.

The rod-shaped object 8 of a fluororesin or hydrocarbon-based thermosetting resin may be introduced into the internal space 22 of the dielectric chamber 2 to assist the plasma excitation of the carrier gas or the raw material gas.

The plasma-excited carrier gas and raw material gas move in the internal space 22 of the dielectric chamber 2, the flow velocities thereof are increased by the nozzle 24, and the gases are ejected from the plasma outlet 23 toward the substrate. After the plasma-excited raw material gas reaches the substrate surface, the coating is formed on the substrate surface by the reaction of the plasma-excited raw material gas.

The spread of the plasma-excited raw material gas is preferably about 20 to 100 mm in diameter when, for example, the distance from the plasma outlet 23 is 50 mm, the diameter is preferably about 20 to 50 mm when the distance is 100 mm, and the diameter is preferably about 50 to 200 mm when the distance is 150 mm.

The shortest straight-line distance between the plasma outlet 23 and the substrate surface to be treated can be appropriately determined in accordance with the shape and material of the substrate, the thickness of the coating, the type of raw material gas, etc. The shortest straight-line distance can be more than 0 and 500 mm or less, preferably 20 to 300 mm. By setting the shortest straight-line distance as such, it is possible to efficiently form a coating having a uniform thickness on the surface of the substrate.

The film formation time can be appropriately determined in accordance with the surface area of the substrate, the thickness of the coating, the type of raw material gas, etc.

Examples of coatings that can be formed by the atmospheric pressure remote plasma CVD apparatus 1 of the present disclosure include diamond-like carbon (DLC) films and silicon oxide (SiOₓ) films.

DLC films include amorphous hydrogenated carbon films (a-C:H) containing up to 50 atomic% of hydrogen atoms. The DLC films can be formed using, as the raw material gas, a hydrocarbon, such as acetylene, methane, ethane, propane, or mixtures thereof.

SiOₓ films are described as SiO:CH, etc., or SiO₂ films, and include films in which C and H derived from an organosilicon compound are bonded in the backbone thereof. The SiOₓ films can be formed using a silicon compound, such as trimethylsilane, tetraethoxysilane, tetramethoxysilane, and hexamethyldisiloxane, or mixtures thereof.

The film formation speed of the coating can be appropriately adjusted in accordance with the supply amount of the raw material gas, the concentration of the raw material gas, the plasma excitation conditions of the raw material gas, etc. The film formation speed of the coating can be, for example, 1 nm/sec to 100 nm/sec, preferably 2 nm/sec to 20 nm/sec, and more preferably 3 nm/sec to 10 nm/sec.

The thickness of the coating can be appropriately determined in accordance with the intended use, and can be, for example, 5 nm to 100 nm, preferably 10 nm to 50 nm, and more preferably 10 nm to 30 nm. By setting the coating thickness to 5 nm or more, desired properties, such as gas barrier properties, can be imparted to the substrate surface. By setting the coating thickness to 100 nm or less, productivity can be increased and costs can be reduced.

The coating may be a multilayer film. In an embodiment, the coating is a multilayer film containing alternating DLC films and SiOₓ films. Such a multilayer film may be formed, for example, by alternately switching the supplied raw material gas after a certain period of time in one atmospheric pressure remote plasma CVD apparatus 1, or it may be formed by supplying different raw material gases to two or more atmospheric pressure remote plasma CVD apparatuses 1, respectively, forming a film in one of the atmospheric pressure remote plasma CVD apparatuses 1, and then further forming a film thereon in another atmospheric pressure remote plasma CVD apparatus 1.

According to the atmospheric pressure remote plasma CVD apparatus and the coating formation method using the atmospheric pressure remote plasma CVD apparatus of the present disclosure, coatings can be formed on three-dimensional shapes, such as plastic bottles and caps for packaging materials, and the formation of barrier coatings of materials, such as polymer materials, which require low-temperature treatment can easily be performed. The atmospheric pressure remote plasma CVD apparatus of the present disclosure can also be used as a plasma surface treatment device without coating formation derived from raw material gas.

The present invention is not limited to the embodiments described above, and various modifications, additions of elements, or improvements are possible within the scope of the spirit of the present invention.

### EXAMPLES

The present invention will be described in more detail below based on the Examples, but the present invention is not limited to such Examples.

Using an atmospheric pressure remote plasma CVD apparatus having the configuration shown in FIG. 1, a DLC (amorphous hydrogenated carbon) coating was formed on the inner surface of a plastic bottle using acetylene (C₂H₂) as the raw material gas.

The specifications of the plastic bottle were as follows.
Material: Polyethylene terephthalate (PET)
Capacity: 350 mL
Outer diameter of the body: 60 mm
Overall length: 150 mm
Body thickness: 0.3 mm

The dielectric chamber had a cylindrical shape, was made of polytetrafluoroethylene, and had an outer diameter of 24 mm, an inner diameter of 20 mm, a length of 360 mm, and a thickness of 2 mm as shown in FIG. 2, and a nozzle having an opening diameter of 5 mm was provided in the plasma outlet thereof.

As the conductor for igniting the plasma, a tungsten needle having a diameter of 3 mm, a length of 100 mm, and a sharp tip was used. The tungsten needle in a floating state suspended by an insulator string, was inserted through the insertion hole at the upper end of the dielectric chamber, was removed after the plasma was ignited, and the insertion hole was then closed.

The plasma gas outlet (nozzle) of the dielectric chamber was inserted 10 mm below the opening top surface of the plastic bottle, and the plastic bottle was mounted on a stage. Thereafter, while supplying argon as the carrier gas to the internal space of the dielectric chamber at a flow rate of 1,500 sccm, the tungsten needle was inserted into the internal space of the dielectric chamber, and after the interior of the dielectric chamber was filled with argon, microwaves having a frequency of 2.45 GHz and an output of 840 W were oscillated in the microwave oscillator. The microwaves supplied from the microwave oscillator propagated through the propagation waveguide, were supplied to the interior of the annular resonator, passed through five horizontal slits and two vertical slits formed at equal intervals in the annular resonator, and were introduced into the microwave confinement chamber, whereby plasma was generated in the dielectric chamber. The microwaves had an output of 1 kHz and a duty ratio (ratio of parts with and without output) of a 1:1 square wave shape.

After it was confirmed that plasma-excited argon gas was ejected from the plasma outlet, the tungsten needle was removed from the dielectric chamber, and while supplying argon gas, acetylene (C₂H₂) gas, which is the raw material gas, was supplied from a gas supply source (cylinder) to the internal space of the dielectric chamber via a flow control valve at a flow rate of 20 sccm, whereby plasma-excited acetylene gas was generated in the dielectric chamber.

After the plasma-excited acetylene gas ejected from the plasma outlet was introduced into the plastic bottle for 10 seconds, the microwave oscillation was stopped, whereby a plastic bottle having a coating formed on the inner surface thereof was obtained. During coating formation, it was visually observed that the plasma-excited acetylene gas was delivered to a distance of at least 15 cm from the plasma outlet.

The coating formed on the inner surface of the plastic bottle was analyzed by X-ray photoelectron spectroscopy (XPS) under vacuum (1 × 10⁻⁶ Pa) conditions using a scanning X-ray photoelectron spectroscopy analyzer Quantera II manufactured by PHI. When the C₁ₛ peak of the coating was analyzed, it was found that a DLC film which contained approximately 50% sp2 carbon and approximately 50% sp3 carbon was formed.

The oxygen permeation amount T of the obtained plastic bottle was 0.043 cc/24 h·pkg when measured using a MOCON oxygen permeability analyzer OX-TRAN MODEL 2/61 (Hitachi High-Tech Science Corporation) under the conditions of a temperature of 37°C and a relative humidity of 70%. The oxygen permeation amount T₀ of a comparative plastic bottle subjected to plasma treatment under the same conditions except that raw material gas was not supplied was 0.045 cc/24 h·pkg. Therefore, the barrier property improvement rate (= (T₀ - T) / T₀ × 100 (%)) was 4.4%.

### INDUSTRIAL APPLICABILITY

According to the atmospheric pressure remote plasma CVD apparatus and coating formation method of the present disclosure, functional coatings, such as DLC films, can be formed on various substrate surfaces.

### REFERENCE SIGNS LIST

- 1: atmospheric pressure remote plasma CVD apparatus
- 2: dielectric chamber
- 21: gas inlet
- 22: internal space
- 23: plasma outlet
- 24: nozzle
- 3: external chamber
- 31: pedestal
- 32, 33: side wall
- 34: lid
- 35: microwave confinement chamber
- 4: flange
- 51: raw material gas supply line
- 52: flow control valve
- 53: carrier gas supply line
- 54: flow control valve
- 55: T-shaped pipe
- 56: lid
- 6: plasma generator (microwave irradiation device)
- 61: slit antenna (slit)
- 62: propagation waveguide
- 63: microwave oscillator
- 64: annular resonator
- 7: conductor
- 71: guide
- 72: cock valve
- 73: insulation sheath
- 8: rod-shaped object
- 81: raw material supply mechanism
- 9: conductor (stage)
- B: plastic bottle
- BI: plastic bottle inner surface
- BM: plastic bottle mouth
- MW: microwave supply region
- PG: plasma-excited gas

## Claims

1. An atmospheric pressure remote plasma CVD apparatus, comprising a dielectric chamber having a gas inlet, an internal space, and a plasma outlet, and a plasma generator which generates plasma in the internal space, wherein the plasma outlet comprises a nozzle having an opening area smaller than an average cross-sectional area of a cross-section orthogonal to a gas flow direction of the internal space.

2. The atmospheric pressure remote plasma CVD apparatus according to claim 1, wherein the dielectric chamber is tubular, and in the longitudinal direction of the dielectric chamber, the gas inlet is arranged at one end of the dielectric chamber and the plasma outlet is arranged at the other end of the dielectric chamber.

3. The atmospheric pressure remote plasma CVD apparatus according to claim 1 or 2, wherein the dielectric chamber comprises at least one selected from the group consisting of glass, quartz, and a fluororesin.

4. The atmospheric pressure remote plasma CVD apparatus according to any one of claims 1 to 3, wherein the plasma generator is a microwave irradiation device.

5. The atmospheric pressure remote plasma CVD apparatus according to any one of claims 1 to 4, wherein the opening area of the nozzle is 0.01 to 0.1 times the average cross-sectional area of the cross-section orthogonal to the gas flow direction of the internal space.

6. The atmospheric pressure remote plasma CVD apparatus according to any one of claims 1 to 5, further comprising a conductor which can be arranged in, inserted into, and removed from the internal space.

7. The atmospheric pressure remote plasma CVD apparatus according to claim 6, wherein the conductor comprises an insulation sheath which extends from the gas inlet of the dielectric chamber.

8. The atmospheric pressure remote plasma CVD apparatus according to any one of claims 1 to 7, further comprising a raw material gas supply line which is open in an upstream part, middle part, or downstream part of the internal space, wherein a plasma-excited carrier gas and a raw material gas are mixed in the internal space.

9. The atmospheric pressure remote plasma CVD apparatus according to any one of claims 1 to 8, comprising a raw material supply mechanism for introducing a fluororesin or hydrocarbon thermosetting resin rod-shaped object into the internal space.

10. The atmospheric pressure remote plasma CVD apparatus according to any one of claims 1 to 9, further comprising a conductor which is arranged downstream of the plasma outlet and to which a negative voltage can be applied, wherein the conductor is configured so that a substrate is arranged between the plasma outlet and the conductor.

11. The atmospheric pressure remote plasma CVD apparatus according to any one of claims 1 to 10, wherein the dielectric chamber has a plurality of plasma outlets, and a total opening area of the nozzles of the plurality of plasma outlets is less than the average cross-sectional area of the cross-section orthogonal to the gas flow direction of the internal space.

12. A method for forming a coating on a surface of a substrate, comprising:
providing an atmospheric pressure remote plasma CVD apparatus comprising a dielectric chamber having a gas inlet, an internal space, and a plasma outlet, and a plasma generator which generates plasma in the internal space, the plasma outlet comprising a nozzle having an opening area smaller than an average cross-sectional area of a cross-section orthogonal to a gas flow direction of the internal space,
arranging a substrate downstream of the plasma outlet,
introducing a carrier gas from the gas inlet,
turning the carrier gas into a plasma in the internal space,
introducing a raw material gas from the gas inlet,
mixing the raw material gas and the plasma-excited carrier gas to generate a plasma-excited raw material gas, and
ejecting the plasma-excited raw material gas from the plasma outlet toward the substrate to form a coating on the surface of the substrate.

13. A method for producing a plastic bottle having a coated inner surface, comprising:
providing an atmospheric pressure remote plasma CVD apparatus comprising a dielectric chamber having a gas inlet, an internal space, and a plasma outlet, and a plasma generator which generates plasma in the internal space, the plasma outlet comprising a nozzle having an opening area smaller than an average cross-sectional area of a cross-section orthogonal to a gas flow direction of the internal space,
arranging a plastic bottle downstream of the plasma outlet,
introducing a carrier gas from the gas inlet,
turning the carrier gas into a plasma in the internal space,
introducing a raw material gas from the gas inlet,
mixing the raw material gas and the plasma-excited carrier gas to generate a plasma-excited raw material gas, and
ejecting the plasma-excited raw material gas from the plasma outlet toward an interior of the plastic bottle to form a coating on an inner surface of the plastic bottle.

14. An atmospheric pressure remote plasma CVD apparatus, comprising a dielectric chamber having a gas inlet, an internal space, and a plasma outlet, and a plasma generator which generates plasma in the internal space, wherein the atmospheric pressure remote plasma CVD apparatus is provided with a conductor which can be arranged in, inserted into, and removed from the internal space.

15. The atmospheric pressure remote plasma CVD apparatus according to claim 14, wherein the conductor comprises an insulation sheath which extends from the gas inlet of the dielectric chamber.

16. An atmospheric pressure remote plasma CVD apparatus, comprising a dielectric chamber having a gas inlet, an internal space, and a plasma outlet, and a plasma generator which generates plasma in the internal space, wherein the atmospheric pressure remote plasma CVD apparatus is provided with a raw material supply mechanism for introducing a fluororesin or hydrocarbon thermosetting resin rod-shaped object into the internal space.
